# EUROPEAN PATENT SPECIFICATION

(11) **EP 3 827 647 B1**
(45) Date of publication and mention of the grant of the patent: **05.11.2025**
(21) Application number: 19735035.8
(22) Date of filing: 14.06.2019
(51) Int. Cl.: H05K 13/04

(54) **SYSTEM AND METHOD OF TRANSITIONING FROM SYNCHRONOUS TO ASYNCHRONOUS DISPENSING**
SYSTEM UND VERFAHREN ZUM ÜBERGANG VON SYNCHRONER ZU ASYNCHRONER AUSGABE
SYSTÈME ET PROCÉDÉ DE TRANSITION DE DISTRIBUTION SYNCHRONE À ASYNCHRONE

(30) Priority: 24.07.2018 US 201816044104
(43) Date of publication of application: 02.06.2021
(73) Proprietor: Illinois Tool Works INC., Glenview, IL 60025 (US)
(72) Inventor: REID, Scott, A., Glenview, IL 60025 (US); LEONARDO, Marzuki, Glenview, IL 60025 (US); READ, Hugh, R., Glenview, IL 60025 (US); AGARWAL, Sunny, Glenview, IL 60025 (US)
(74) Representative: HGF
(86) International application number: PCT/US2019/037183
(87) International publication number: WO 2020/023124

(56) References cited:
- WO-A1-2016/007596
- US-A1- 2017 290 168

## Description

### BACKGROUND OF THE INVENTION

### 1. Field of the Invention

The present disclosure relates generally to methods and apparatus for dispensing a viscous material on a substrate, such as a printed circuit board, and more particularly to a method and an apparatus for dispensing material on a substrate with two or more dispensing units between synchronous and asynchronous modes.

### 2. Discussion of Related Art

There are several types of prior art dispensing systems used to dispense precise amounts of liquid or paste for a variety of applications. One such application is the assembly of integrated circuit chips and other electronic components onto circuit board substrates. In this application, automated dispensing systems are used for dispensing dots of liquid epoxy or solder paste, or some other related material, onto circuit boards. Automated dispensing systems are also used for dispensing lines of underfill materials and encapsulents, which may be used to mechanically secure components to the circuit board. Exemplary dispensing systems described above include those manufactured and distributed by ITW EAE of Glenview, Illinois under the brand name CAMALOT^{®}.

In a typical dispensing system, a pump and dispenser assembly is mounted to a moving assembly or gantry for moving the pump and dispenser assembly along three mutually orthogonal axes (X, Y, Z) using servomotors controlled by a computer system or controller. To dispense a dot of liquid on a circuit board or other substrate at a desired location, the pump and dispenser assembly is moved along the co-planar horizontal X and Y axes until it is located over the desired location. The pump and dispenser assembly is then lowered along the perpendicularly oriented vertical Z axis until a nozzle/needle of the pump and dispenser assembly is at an appropriate dispensing height over the substrate. The pump and dispenser assembly dispenses a dot of liquid, is then raised along the Z axis, moved along the X and Y axes to a new location, and is lowered along the Z axis to dispense the next liquid dot. For applications such as encapsulation or underfilling as described above, the pump and dispenser assembly is typically controlled to dispense lines of material as the pump and dispenser are moved in the X and Y axes along the desired path of the lines.
The production rate of such dispensing systems, in some cases, may be limited by the rate at which a particular dispense pump assembly can accurately and controllably dispense dots or lines of material. In other cases, the production rate of such systems may be limited by the rate at which parts can be loaded into and out of the machine. In still other cases, the production rate of such systems may be limited by process requirements, such as the time required to heat a substrate to a particular temperature, or the time required for a dispensed material to flow, as in underfill applications. In all cases and applications, there is some limit to the throughput capability of a single dispense system.

During the manufacture of integrated circuits, production requirements often exceed the throughput capabilities of a single dispensing system. To overcome the throughput limitations of a single dispensing system, various strategies are applied to improve the production process. Once such strategy is to configure the dispensing system with two or more dispensing units or heads to dispense material simultaneously on two separate and identical substrates or on a substrate having two identical patterns. Reference can be made to U.S. Patent Nos. 7,833,572, 7,923,056, 8,230,805, 9,374,905, 9,775,250 and 9,936,585, which are owned by the assignee of the present disclosure, Illinois Tool Works Inc. of Glenview, Illinois.

US 2017/290168 discusses a method and apparatus for automatically adjusting dispensing units of a dispenser. WO 2016/007596 discusses dual applicator fluid dispensing methods and systems.

### SUMMARY OF THE INVENTION

One aspect of the present disclosure is directed to a method of dispensing material in accordance with the appended independent claims 1 and 3. Preferred embodiments are to be found in appended dependent claims. The method according to claim 1 comprising: delivering an electronic substrate to a dispense position, the electronic substrate having at least two identical patterns; acquiring data relative to the at least two patterns; determining whether the at least two patterns are properly suited for simultaneous dispensing; and if properly suited for simultaneous dispensing, performing simultaneous dispense operations on the at least two patterns based on the acquired data in a synchronous mode of operation, and if not properly suited for simultaneous dispensing, asynchronously performing one of (1) a single dispense operation on one of the first pattern and the second pattern, and (2) no dispense operation.

The method includes triggering asynchronous mode by determining that at least one of the at least two patterns are not properly suited for simultaneous dispensing within a predetermined tolerance. Asynchronous mode may be triggered and at least one pattern is skipped by failing to recognize one of the at least two patterns. Asynchronous mode may be triggered and at least one pattern is skipped due to bad mark data associated with at least one of the at least two patterns. Asynchronous mode may be triggered and at least one pattern is skipped by assigning a bad mark to data acquired from previous processing of an electronic substrate having at least two patterns. The step of acquiring data may include capturing and processing at least one image of the at least two patterns. Asynchronous mode may be triggered by determining that at least one of the at least two patterns are not properly suited for simultaneous dispensing within a predetermined tolerance. Asynchronous mode may be triggered and at least one pattern is skipped by failing to recognize one of the at least two patterns. Asynchronous mode may be triggered and at least one pattern is skipped by determining the at least one image includes bad mark data associated with at least one of the at least two patterns. Asynchronous mode may be triggered and at least one pattern is skipped by inspecting a partially dispensed pattern and determining a defect.

The method according to claim 3 comprising: delivering a first electronic substrate to a first dispense position; delivering a second electronic substrate to a second dispense position; acquiring data relative to the first electronic substrate and the second electronic substrate; determining whether the first electronic substrate and the second electronic substrate are properly suited for simultaneous dispensing; and if properly suited for simultaneous dispensing, performing simultaneous dispense operations on the first electronic substrate and the second electronic substrate based on the acquired data in a synchronous mode of operation, and if not properly suited for simultaneous dispensing, asynchronously performing one of (1) a single dispense operation on one of the first electronic substrate and the second electronic substrate, and (2) no dispense operation.

The method includes triggering asynchronous mode by determining that at least one of the first electronic substrate and the second electronic substrate are not properly suited for simultaneous dispensing within a predetermined tolerance. Asynchronous mode may be triggered and at least one substrate is skipped by failing to recognize one of the first electronic substrate and the second electronic substrate. Asynchronous mode may be triggered and at least one substrate is skipped due to bad mark data associated with at least of the first electronic substrate and the second electronic substrate. Asynchronous mode may be triggered and at least one substrate is skipped due to bad mark data acquired from previous processing of at least one of the first electronic substrate and the second electronic substrate. The step of acquiring data may include capturing and processing at least one image of the first electronic substrate and the second electronic substrate. Asynchronous mode may be triggered by determining that at least one of the first electronic substrate and the second electronic substrate are not properly suited for simultaneous dispensing within a predetermined tolerance. Asynchronous mode may be triggered and at least one substrate is skipped by failing to recognize at least one of the first electronic substrate and the second electronic substrate. Asynchronous may be triggered and at least one substrate is skipped by determining the at least one image includes bad mark data associated with at least one of the substrates. Asynchronous mode may be triggered and at least one substrate is skipped by inspecting a partially dispensed pattern and determining a defect.

The present disclosure will be more fully understood after a review of the following figures, detailed description and claims.

### BRIEF DESCRIPTION OF THE DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a side schematic view of a dispenser;
FIGS. 2-4 are schematic views of a dispenser;
FIGS. 5 and 6 are schematic views of a portion of another dispenser of an embodiment of the disclosure used to perform methods of the disclosure;
FIG. 7 illustrates the substrates shown in FIG. 5 in an exaggerated skewed position; and
FIG. 8 is a top plan view of two offset parts provided in an Auer boat.

### DETAILED DESCRIPTION OF THE PREFERRED EMBODIMENTS

For the purposes of illustration only, and not to limit the generality, the disclosure will now be described in detail with reference to the accompanying figures. This disclosure is not limited in its application to the details of construction and the arrangement of components set forth in the following description or illustrated in the drawings. The teachings disclosed herein are capable of other embodiments and of being practiced or being carried out in various ways. Also the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

As mentioned above, in some cases, multiple independent dispensing systems are sometimes used to increase the production of dispense operations. This solution is often expensive, requiring multiple machines, additional manufacturing space and in some cases multiple machine operators. In typical operations, manufacturing floor space is both limited and expensive. It is therefore desirable to reduce the "footprint" of each manufacturing system on the manufacturing floor and to reduce the number of separate machines that need to be operated and maintained.

For some applications, multiple instances of the same circuit pattern are fabricated on a common substrate. A common example is a circuit pattern for a cell phone, wherein four or more patterns may be disposed on a single substrate. In such cases, there is often a fixed and uniform offset between the multiple instances of the circuit patterns, which may be disposed on a common substrate and separated from one another after completion along perforations. Furthermore, it is known in the industry that a dispensing system with multiple dispensing units or pumps may be utilized to increase throughput. In such systems, the offset distance between the multiple dispensing pumps may be adjusted to be substantially the same as the offset distance between the multiple circuit distances, and if the accuracy of this offset adjustment is within the accuracy requirements of the resultant dispense pattern, then the multiple dispensing pumps can be positioned simultaneously by a single X, Y, Z gantry and operated simultaneously.

When a dispensing system is presented with a substrate or component to be dispensed upon, it is typical that an automatic vision system is used to locate and calibrate the actual position of the part and/or critical features within the part. This locating and calibrating allows the system to compensate for variations in either the substrate or component itself or in the fixing of the substrate or component relative to the coordinate system of the dispensing unit positioning system.

When multiple dispensing units or heads are utilized in parallel to achieve a high collective throughput, e.g., dispensing on two substrates at the same time, it is typical that the multiple dispensing units are programmed to perform substantially the same task on substantially identical components. However, because of slight variations in either the components themselves or in the fixing of the components relative to the positioning systems, corrections may need to be applied independently to each of the multiple dispense units. Since these corrections are unique to each of the multiple dispense units, it is necessary that each of the dispensing units be independently positioned relative to its substrate. Accordingly, dispensers configured with multiple dispensing units are more adapted for coarse dispensing applications in which accurate dispensing is not critical.

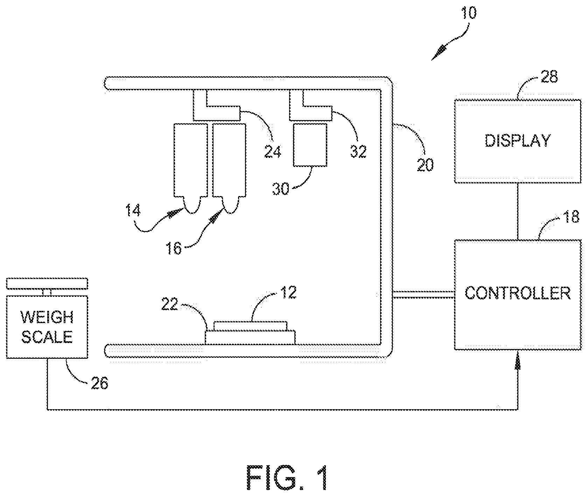

FIG. 1 schematically illustrates a dispensing system, generally indicated at 10, according to one embodiment of the present disclosure. The dispensing system 10 is used to dispense a viscous material (e.g., an adhesive, encapsulent, epoxy, solder paste, underfill material, etc.) or a semi-viscous material (e.g., soldering flux, etc.) onto an electronic substrate 12, such as a printed circuit board or semiconductor wafer. The dispensing system 10 may alternatively be used in other applications, such as for applying automotive gasketing material or in certain medical applications or for applying conductive inks. It should be understood that references to viscous or semi-viscous materials, as used herein, are exemplary and intended to be non-limiting. The dispensing system 10 includes several dispensing units, for example, first and second dispensing units, generally indicated at 14 and 16, respectively, and a controller 18 to control the operation of the dispensing system. It should be understood that dispensing units also may be referred to herein as dispensing pumps and/or dispensing heads. Although two dispensing units are shown, it should be understood that more than two dispensing units may be employed.

The dispensing system 10 may also include a frame 20 having a base or support 22 for supporting the electronic substrate 12, a dispensing unit gantry 24 movably coupled to the frame 20 for supporting and moving the dispensing units 14, 16, and a weight measurement device or weigh scale 26 for weighing dispensed quantities of the viscous material, for example, as part of a calibration procedure, and providing weight data to the controller 18. A conveyor system (not shown) or other transfer mechanism, such as a walking beam, may be used in the dispensing system 10 to control loading and unloading of electronic substrates to and from the dispensing system. The gantry 24 can be moved using motors under the control of the controller 18 to position the dispensing units 14, 16 at predetermined locations over the electronic substrate. The dispensing system 10 may include a display unit 28 connected to the controller 18 for displaying various information to an operator. There may be an optional second controller for controlling the dispensing units. Also, each dispensing unit 14, 16 can be configured with a Z axis sensor to detect a height at which the dispensing unit is disposed above the electronic substrate 12 or above a feature mounted on the electronic substrate. The Z axis sensor is coupled to the controller 18 to relay information obtained by the sensor to the controller.

Prior to performing a dispensing operation, as described above, the electronic substrate, e.g., the printed circuit board, must be aligned or otherwise in registration with a dispensing unit of the dispensing system. The dispensing system further includes a vision system 30, which, in one embodiment, is coupled to a vision system gantry 32 movably coupled to the frame 20 for supporting and moving the vision system. In another embodiment, the vision system 30 may be provided on the dispensing unit gantry 24. As described, the vision system 30 is employed to verify the location of landmarks, known as fiducials, or components on the electronic substrate. Once located, the controller can be programmed to manipulate the movement of one or more of the dispensing units 14, 16 to dispense material on the electronic substrate.

Systems and methods of the present disclosure are directed to dispensing material onto an electronic substrate, e.g., a printed circuit board. The description of the systems and methods provided herein reference exemplary electronic substrates 12 (e.g., printed circuit boards), which are supported on the support 22 of the dispensing system 10. In one embodiment, the dispense operation is controlled by the controller 18, which may include a computer system configured to control material dispensing units. In another embodiment, the controller 18 may be manipulated by an operator. The controller 18 is configured to manipulate the movement of the vision system gantry 32 to move the vision system so as to obtain one or more images of the electronic substrate 12. The controller 18 further is configured to manipulate the movement of the dispensing unit gantry 24 to move the dispensing units 14, 16 to perform dispensing operations.

Embodiments of the present disclosure offer alternative and competitive means to accurately dispense simultaneously on one or more electronic substrates or two or more patterns associated with a single electronic substrate in a synchronous mode or an asynchronous mode. Specifically, if the electronic substrates are not properly aligned as determined by the controller, the dispensing system can switch from a synchronous mode in which two electronic substrates or patterns are to be dispensed upon to an asynchronous mode in which only one electronic substrate or pattern is dispensed upon. The methods disclosed herein further support the use of various types of dispensing pumps, including, but not limited to, auger, piston and jetting pumps.

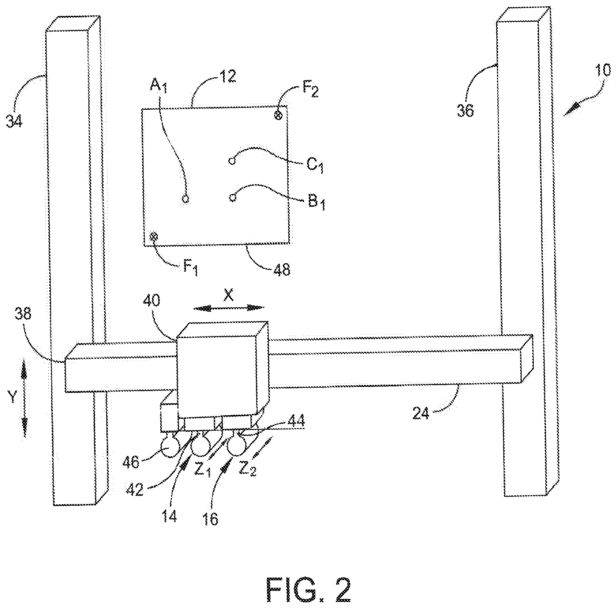

Referring to FIG. 2, the gantry 24 may be configured to include a left-hand side rail 34, a right-hand side rail 36 and a beam 38 that extends between the two side rails. The beam 38 is configured to move in a Y axis direction along the side rails 34, 36 to achieve Y axis movement of the dispensing units 14, 16. X axis movement of the dispensing units 14, 16 is achieved by a carriage device 40 mounted on the beam 38. Specifically, the carriage device 40 houses the dispensing units 14, 16 and is configured to move along the length of the beam 38 in the X axis direction to move the dispensing units over desired locations of the substrate 12 positioned on the base 22. In a certain embodiment, movement of the gantry 24 (i.e., movement of the beam 38 and the carriage device 40) in the X-Y plane may be achieved by employing ball screw mechanisms driven by respective motors as is well known in the art.

The dispensing units 14, 16, as mentioned above, are capable of achieving Z axis movement by means of independent Z drive mechanisms, which are designated at 42, 44, respectively, in FIG. 2. The amount of Z axis movement may be determined by measuring the distance between the tip of a needle/nozzle (not shown) of one of the dispensing units 14 and/or 16 and the substrate 12. When moving, one or both of the dispensing units 14, 16 may be positioned at a nominal clearance height above the substrate 12. The clearance height may be maintained at a relatively consistent elevation above the substrate 12 when moving from one dispense location to another dispense location. Upon reaching a predetermined dispense location, the Z drive mechanism 42, 44 lowers its respective dispensing unit 14, 16 to the substrate so that dispensing of material on the substrate 12 may be achieved.

In certain embodiments, a common gantry that moves both of the dispensing units together may control the dispensing units. Thus, a single Z drive mechanism may be provided. This configuration is particularly suited for dispensing units that stream, jet or launch viscous material onto the substrate. The dispensing units that stream, jet or launch viscous material may be referred to as non-contact dispensing units in which Z axis movement is not required, but may be provided.

Still referring to FIG. 2, the dispensing units 14, 16 are moved over the substrate 12 in such a manner to perform a dispense operation with one or both of the dispensing units. However, prior to dispensing, the position of the substrate 12 with respect to the dispensing units 14, 16 is determined so that accurate dispensing may take place. Specifically, the carriage device 40 includes an optical element or camera 46 that is configured to take an image of the substrate 12. Although the camera 46 is shown to be mounted on the carriage device 40, it should be understood that the camera may be separately mounted on the beam 38 or on an independent gantry. The camera 46 may be referred to herein as a "vision system" or an "imaging system." To align the substrate 12 with the dispensing units 14, 16 and gantry 24, images of at least two fiducials (F₁, F₂) are taken by the camera 46. If the substrate 12 is out of position, the gantry 24 may be manipulated to account for the actual position of the substrate. In one embodiment, the camera 46 may be calibrated to determine camera-to-needle offset distances for each of the dispensing units 14, 16 in a manner described in greater detail below.

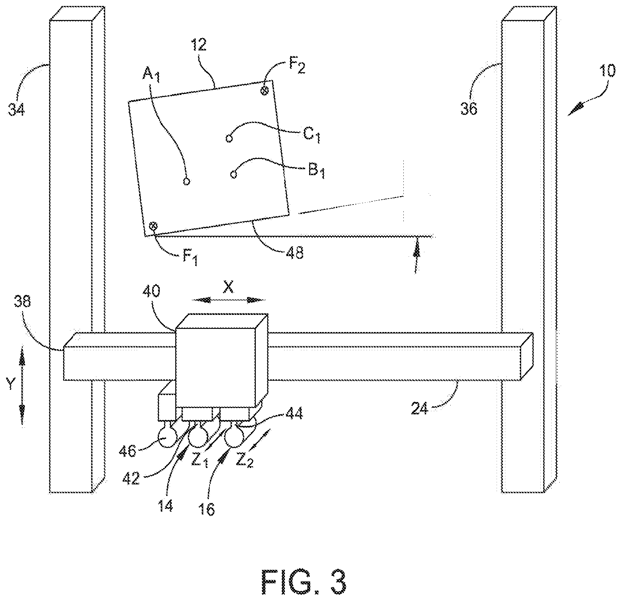

FIG. 3 illustrates a substrate 12 in an exaggerated skewed position. As shown, the bottom edge 48 of the substrate 12 is at an angle 50 with respect to the X axis. The gantry 24 moves the camera 46 over the substrate 12 to a first position in which the camera takes an image of a first fiducial F₁, which is positioned at the lower left-hand corner of the substrate 12 as viewed in FIG. 3. After capturing an image of the first fiducial F₁, the gantry 24 moves the camera 46 over the substrate 12 to a second position in which the camera takes an image of a second fiducial F₂, which is positioned at the upper right-hand corner of the substrate. Based on the images of the first and second fiducials F₁, F₂, the controller 18 can manipulate the gantry 24 to perform an accurate dispense operation with either one of the dispensing units. As shown in FIG. 3, dispense operations are performed at locations A₁, B₁ and C₁, for example. However, as can be appreciated, any number of dispense operations may be performed with one or both of the dispensing units 14, 16. For example, instead of dispensing material at certain locations, lines of material may be dispensed on the substrate 12.

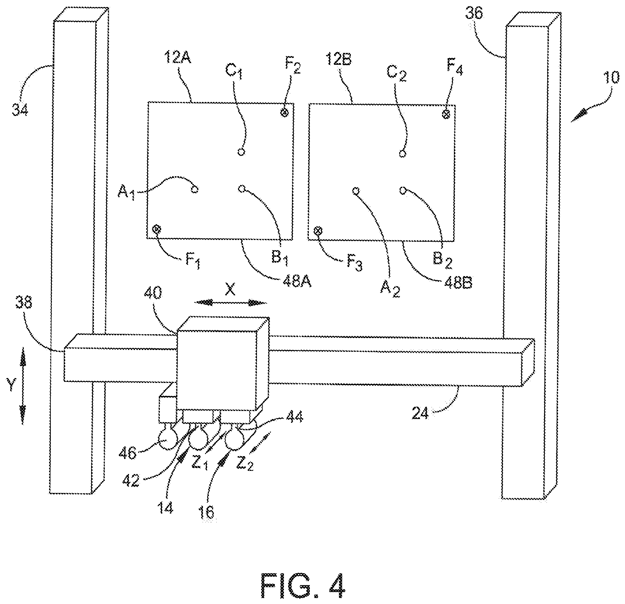

Turning to FIG. 4, the dispenser 10 may be configured to perform dispense operations on two substrates 12A, 12B, which may be connected with one another (as with the cell phone configuration described above) or may be positioned separately on the base 22 in a tray, for example. For the substrates 12A, 12B illustrated in FIG. 4, the substrates are each in an aligned or known position. Thus, dispensing operations at locations A₁, B₁ and C₁ on the first substrate 12A with either dispensing unit 14 or 16 or both may be initiated. Once dispensing on the first substrate 12A is finished, the carriage device may be moved along the beam 30 in an X axis direction so that a dispensing operation may take place at locations A₂, B₂ and C₂ on the second substrate 12B with either dispensing unit 14 or 16 or both. Obviously, the movement of the dispensing units 14, 16 is achieved, as discussed above, by moving the beam 38 in the Y axis direction and the carriage device 40 in the X axis direction.

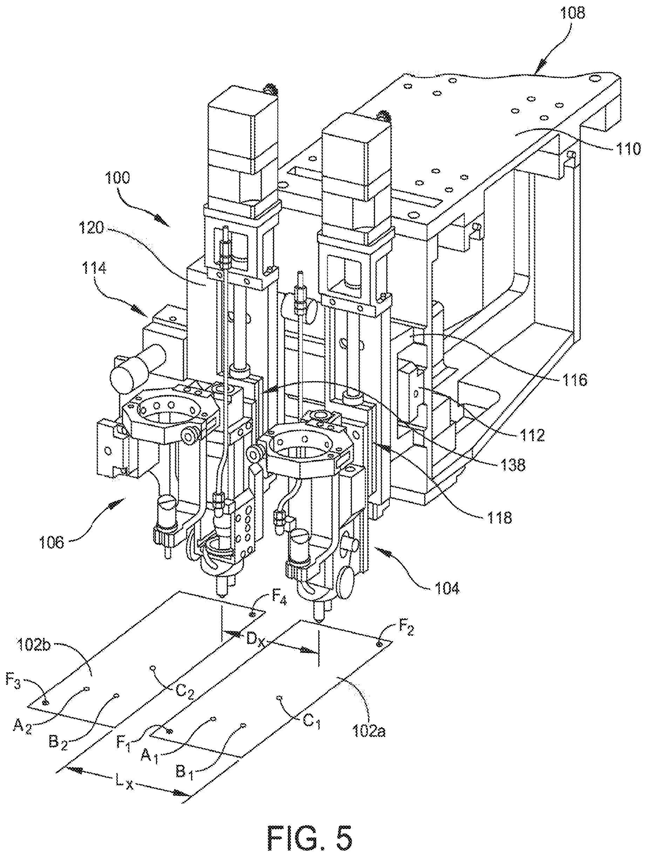

Referring to FIG. 5, a dispenser of another embodiment is generally indicated at 100. As shown, the dispenser 100 is configured to dispense a viscous material (e.g., adhesive, encapsulent, epoxy, solder paste, underfill material, etc.) or a semi-viscous material (e.g., soldering flux, etc.), or a substantially non-viscous material (e.g., an ink) onto electronic substrates 102a, 102b, such as printed circuit boards or semiconductor wafers. The substrates 102a, 102b may embody any type of surface or material upon which dispensing is required. The dispenser 100 includes first and second dispensing units or heads, generally indicated at 104 and 106, respectively, which are secured to a gantry 108, similar to gantry 24 of dispenser 10, and operated under the control of a controller, such as controller 18, to control the operation of the dispenser. Although two dispensing units 104, 106 are shown, it should be understood that more than two dispensing units may be provided.

The construction of gantry 108 is substantially similar to the construction of gantry 24 for dispenser 10. As is well known in the art of printed circuit board fabrication, a conveyor system (not shown) may be used in the dispenser 100 to control loading and unloading of substrates to and from the dispenser. The gantry 108 can be moved using motors under the control of the controller in the X axis and Y axis directions to position the dispensing units 104, 106 at predetermined locations over the substrate 102.

As with gantry 24 of dispenser 10, the gantry 108 may be configured to include a beam that extends between two side rails. The beam is configured to move in a Y axis direction along the side rails to achieve Y axis movement of the dispensing units 104, 106. X axis movement of the dispensing units 104, 106 is achieved by a carriage device 110 mounted on the beam. Specifically, the carriage device 110 supports the dispensing units 104, 106 and is configured to move along a width of the beam in the X axis direction to move the dispensing units over desired locations of the substrate 102 positioned on a base of the dispenser. In a certain embodiment, movement of the gantry 108 (i.e., movement of the beam and the carriage device) in the X-Y plane may be achieved by employing ball screw mechanisms driven by respective motors or other linear motion drive components as is well known in the art.

The first dispensing unit 104 and the second dispensing unit 106 are coupled to the carriage device 110 by a linear bearing 112 secured to the carriage device 110. In one embodiment, the first dispensing unit 104 is fixedly secured to the linear bearing 112 and the second dispensing unit 106 is coupled to the linear bearing by an automatic adjustment mechanism, which is generally indicated at 114 in FIG. 5. It should be understood that the second dispensing unit 106 may be fixed to the linear bearing 112 and the first dispensing unit 104 may be coupled to the automatic adjustment mechanism 114, and fall within the scope of the present disclosure. As shown, the first dispensing unit 104 and the second dispensing unit 106 are offset from one another at a distance, with the automatic adjustment mechanism 114 being configured to adjust the distance by moving the second dispensing unit a relatively small distance in the X axis and Y axis directions.

In the shown embodiment, the first dispensing unit 104 is secured to the linear bearing 112 by a mounting assembly having a mounting block 116, which is secured to the first dispensing unit and to the linear bearing. The mounting assembly associated with the first dispensing unit 104 further includes a Z axis movement mechanism, generally indicated at 118, which enables the Z axis movement of the first dispensing unit. The Z axis movement mechanism 118 is particularly suited for lowering the first dispensing unit during a dispensing operation, e.g., for an auger-type dispensing unit.

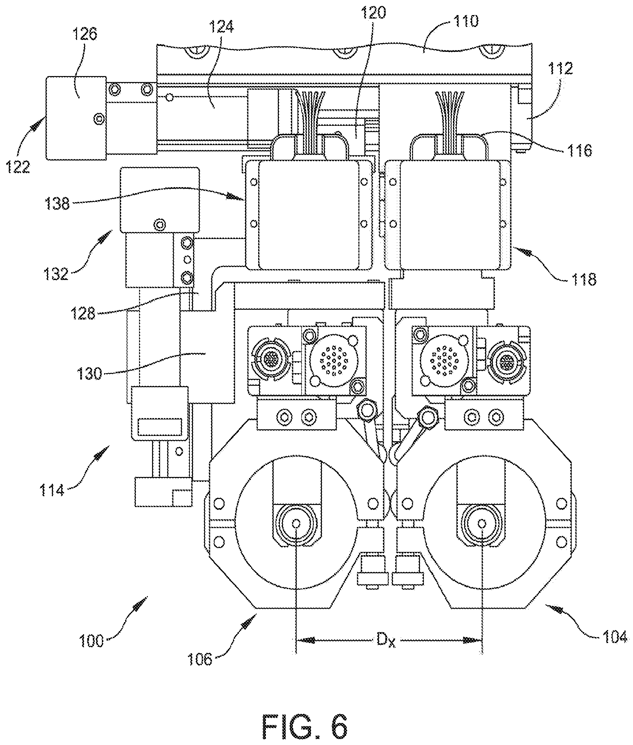

With additional reference to FIG. 6, the automatic movement mechanism 114 includes a mounting block 120, which is secured to the second dispensing unit 106 and configured to ride along the linear bearing 112 to provide movement in the X axis direction. The automatic adjustment mechanism 114 further includes a first motor assembly generally indicated at 122 configured to move the mounting block 120, and the second dispensing unit 106, along the linear bearing 112. In one embodiment, the first motor assembly 122 includes a ball screw driven linear actuator 124, which is driven by a mechanically coupled rotary servo motor 126 or other electro-mechanical linear drive device. Thus, the automatic adjustment mechanism 114 is capable of adjusting the second dispensing unit 106 in the X axis direction while the first dispensing unit 104 remains stationary. In a certain embodiment, the automatic adjustment mechanism 114 is capable of providing a relatively short amount of X axis movement of the second dispensing unit 106 to provide fine adjustment of the second dispensing unit relative to the first dispensing unit 104.

As mentioned above, the automatic adjustment mechanism 114 is also capable of adjusting the second dispensing unit 106 in the Y axis direction in the manner described below. Specifically, the automatic adjustment mechanism 114 further includes a first bracket 128 secured to the mounting block 120. As shown, the first bracket 128 extends in a direction perpendicular to a direction of the linear bearing 112 in the Y axis direction. The automatic adjustment mechanism 114 further includes a second bracket 130 secured to the second dispensing unit 106 and configured to ride along the first bracket 128 thereby providing a small amount of movement of the second dispensing unit in the Y axis direction. The automatic adjustment mechanism 114 further includes a second motor assembly 132 configured to move the second bracket 130 along the first bracket 128 thereby moving the second dispensing unit 106. In one embodiment, the second motor assembly 132 includes a ball screw driven linear actuator 134, which is driven by a mechanically coupled rotary servo motor 136 or other electro-mechanical linear drive device.

Similar to the first dispensing unit 104, the second dispensing unit 106 includes a Z axis movement mechanism, generally indicated at 138, which enables the Z axis movement of the second dispensing unit. The Z axis movement mechanism 138 is particularly suited for lowering the first dispensing unit during a dispensing operation, e.g., for an auger-type dispensing unit.

In other embodiments, the automatic adjustment mechanism 114 can be configured to move the first dispensing unit 104 in an X axis direction and a Y axis direction, or configured to move the first dispensing unit in one of an X axis direction and a Y axis direction and to move the second dispensing unit 106 in the other of the Y axis direction and the X axis direction.

As discussed with dispenser 10, the dispenser 100 includes a vision system, such the camera 38 of dispenser 10, and the gantry 108 is capable of moving the camera over the substrates 102a, 102b to capture images of the substrate to align the substrate with the dispensing units 104, 106. With the assistance of the camera, the second dispensing unit 106 may be automatically adjusted by the automatic adjustment mechanism 114.

With dispenser 100, the second dispensing unit 106 may be offset from the first dispensing unit 104 a predetermined distance D_{X}. In particular, as discussed above, the gantry 108 moves the camera 38 over the substrate, e.g., substrate 102a, to a first position in which the camera takes an image of a first fiducial F₁. After capturing an image of the first fiducial F₁, the gantry 108 moves the camera 38 over the substrate 102a to a second position in which the camera takes an image of a second fiducial F₂. Based on the images of the first and second fiducials F₁, F₂, the controller 18 can manipulate the gantry 108 to perform an accurate dispense operation with either one of the dispensing units 104 or 106.

For substrates 102a, 102b illustrated in FIG. 5, the substrates are illustrated in an aligned or known position to begin dispensing operations at locations A₁, B₁ and C₁ on the first substrate 102a, this time with the first dispensing unit 104, for example. Once dispensing on the first substrate 102a is finished with the first dispensing unit 104, instead of moving the carriage device 110 in the X axis direction along the beam as with the dispenser 10 shown in FIGS. 2-4, the carriage device 110 does not require any movement other than to move the second dispensing unit 106 between the locations requiring material.

Specifically, the second dispensing unit 106 is in a suitable position over the second substrate 102b to perform dispensing operations at locations A₂, B₂ and C₂. As shown, the adjustment mechanism 114 is coupled to the second dispensing unit 106 a predetermined distance D_{X}, which may be manipulated so that it achieves a length that is equivalent to the distance L_{X} between the first and second substrates. In this particular example, the locations A₂, B₂ and C₂ on the second substrate 102b correspond to the locations A₁, B₁ and C₁ on the first substrate 102a. Again, the movement of the dispensing units 104, 106 is achieved in the X-Y plane, as discussed above, by moving the carriage device 110 in the X axis direction and by moving the beam in the Y axis direction. Z axis movement is achieved by the independent Z drive mechanisms 118, 138 associated with the first and second dispensing units 104, 106, respectively.

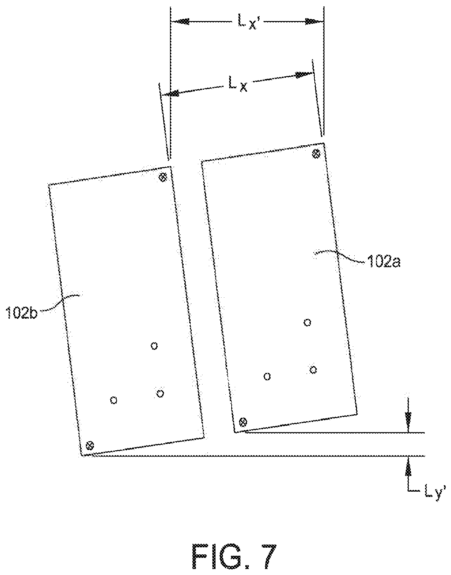

FIG. 7 illustrates the substrates 102a, 102b shown in FIG. 5, with the substrates in an exaggerated skewed position. As shown, the bottom edges of substrates 102a, 102b, respectively, are at an angle with respect to the X axis. To determine the locations or positions of both substrates 102a, 102b, the gantry moves the camera over the first substrate 102a to a first position in which the camera takes an image of a first fiducial F₁ of the first substrate 102a, which is positioned at the lower left-hand corner of the first substrate as viewed in FIG. 7. After capturing an image of the first fiducial F₁, the gantry moves the camera over the first substrate 102a to a second position in which the camera takes an image of a second fiducial F₂, which is positioned at the upper right-hand corner of the first substrate.

For the second substrate 102b, the gantry moves the camera over the second substrate to a third position in which the camera takes an image of the third fiducial F₃, which is positioned at the lower left-hand corner of the second substrate. After capturing an image of the third fiducial F₃, the gantry moves the camera over the second substrate 102b to a fourth position in which the camera takes an image of the fourth fiducial F₄, which is positioned at the upper right-hand corner of the second substrate. Based on the images of the first, second, third and fourth fiducials, F₁, F₂, F₃, F₄, respectively, the distance D_{X} (FIG. 5) of the second dispensing unit 106 with respect to the first dispensing unit 104 may be manipulated based on the distance L_{X} between the first and second substrates 102a, 102b. Specifically, the adjustment mechanism 114 may be manipulated to establish the second dispensing unit 106 a predetermined distance D_{X} from the first dispensing unit 104.

As shown in FIG. 7, dispense operations are performed at locations A₁, B₁ and C₁ with the first dispensing unit 104 and dispense operations are performed at locations A₂, B₂ and C₂ with the second dispensing unit 106. In one embodiment, dispensing may be achieved by first manipulating the first dispensing unit 104 to dispense material at locations A₁, B₁ and C₁ and then manipulating the second dispensing unit 106 to dispense material at locations A₂, B₂ and C₂. In another embodiment, the first dispensing unit 104 may be manipulated to dispense material at location A₁ and then the second dispensing unit 106 may be manipulated to dispense material at A₂. Next, the first dispensing unit 104 may be manipulated to dispense material at location B₁ and then the second dispensing unit 106 may be manipulated to dispense material at B₂. And finally, the first dispensing unit 104 may be manipulated to dispense material at location C₁ and then the second dispensing unit 106 may be manipulated to dispense material at C₂. Some other dispense sequence may also be performed based on the optimal movements of the first and second dispensing units 104, 106, which will be described below.

Thus, for a dispenser having two dispensing units 104, 106, based on the determination of the locations of the first, second, third and fourth fiducials, F₁, F₂, F₃, F₄, respectively, the angle of the first and second substrates 102a, 102b with respect to the X axis may be determined. As shown in FIG. 7, the L_{X'} and L_{Y'} offset distances may be determined so that accurate dispense operations may take place. Accordingly, for a dispenser having multiple dispensing units, the distance and relative position of each of the multiple dispensing units may be configured to match the distance and relative spacing between each of the multiple substrates or components. After collecting and analyzing alignment information from an automatic vision alignment system, a first of the multiple dispensing units is positioned over a first dispense location on the first substrate or component. After performing a dispense operation, the gantry may be manipulated to make any required X-Y plane position adjustment that may be necessary to align a second of the multiple dispensing units over the corresponding first dispensing location of the second of the multiple substrates or components. Since the distance and relative position between each of the multiple dispense units is substantially similar to, although not necessarily identical to, the distance and relative position between each of the multiple substrates or components, any such adjustment of the gantry will be very small and thus rapidly performed. Each of the remaining multiple dispense units may be similarly utilized to dispense material at the corresponding first dispense location on each of the remaining substrates or components before any large X and Y gantry motion is required. However, if the number of substrates or components is greater than the number of dispense units, then the gantry may need to be repositioned to complete the dispensing operations on all of the substrates. The method is repeated to dispense each of the second and subsequent dispense locations. It should be understood that steps may be interchanged as may be dictated by either throughout or process improvements.

As discussed above, in one embodiment, the dispensing units 104, 106 may be mounted on separate Z drive mechanisms. This configuration enables the performance of independent operations when appropriate, including but not limited to dispensing, cleaning (as by an automatic needle/nozzle cleaner, for example), purging and calibration (either the X/Y axes position or the Z axis position). However, it should be noted that each dispenser may be particularly suited for non-contact dispensing, such as the streaming or jetting of material from the needle/nozzle of dispensing unit. When configured for non-contact dispensing, the dispensing operation may be performed with the two (or more) dispensing units that are mounted on a single Z drive mechanism.

With this particular configuration, the two dispensing units are both positioned over their respective locations on the two (or more) substrates. Specifically, when positioning the first dispensing unit 104 nearly exactly over a given dispense position on the first substrate 102a, the second dispensing unit 106 is in an approximately correct position over the second substrate 102b. Next, the first dispensing unit 104 performs a first dispense operation on the first substrate 102a. Once completed, the second dispensing unit 106 is moved a minor amount to correct its location over the second substrate 102b so as to enable the performance of a second dispense operation on the second substrate. Since non-contact dispensing does not require a Z axis direction of movement, having the first and second dispensing units 104, 106 mounted on a common Z drive mechanism does not preclude independent dispensing from each of the dispensing units.

As discussed above, when determining the offset distance between multiple substrates, or multiple patterns within a single substrate, the camera may be operated to take images of known reference points, such as fiducials, which are used to determine the offset distance. However, the offset distance may be determined by the operator of the dispenser during the set-up of the dispenser based on known configurations. In addition, as described above, the exact offset distance is not necessary. A more coarse distance may be appropriate. Specifically, while a more precise offset distance would serve to minimize any corrective move required of the second dispensing unit (or the first dispensing unit if the second dispensing unit is first used), an imprecise offset distance would not preclude or otherwise negatively impact a precise second dispense operation. The actual relative distance between the two or more dispensing units may be measured and therefore corrected for inaccuracies in the setting of the offset distance.

In certain embodiments, when dispensing on multiple substrates or multiple patterns provided on a single substrate, each may have its own corresponding set of local alignment fiducials. Alternatively, the substrates may have sets of global fiducials used to align the substrates at once. In a typical process program, the locations of many of the dispensing sites are known, generally being defined relative to the alignment fiducial locations. Accordingly, once the actual locations of the fiducials have been measured using the camera, the actual positions of the many dispense locations may be calculated, including those locations associated with multiple instances of a repeated pattern. Since each of the multiple dispensing units mounted on the gantry has its own camera-to-needle offset distance, which may be separately learned or calibrated as described above, and since each of the multiple dispensing units may be operated at separate times, the proper position corrections for each and every dispense location may be separately and accurately applied to each of the multiple dispensing units.

It should be observed that the dispenser may be operated to perform dispense operations with multiple dispensing units that operate independently from each other. The camera to needle offset distance may be calibrated by the dispenser, or be selected by the operator of the dispenser. Prior to dispensing, the camera-to-needle offset distances may be determined. Additionally, locations of the first and second dispensing units may be calibrated to determine their respective locations prior to dispensing. Finally, the relative offset distance between each of the dispensing units may be nominally (not precisely) calculated to match the relative pitch between multiple instances of a repeated substrate pattern.

Thus, an exemplary dispense operation for two substrates or for two substrate patterns may consist of the following steps: delivering a first electronic substrate pattern to a dispense position; delivering a second electronic substrate pattern to a dispense position; aligning the first electronic substrate pattern with a first dispensing unit; positioning the second dispensing unit a predetermined distance from the first dispensing unit; dispensing material from the first dispensing unit at desired locations on the first electronic substrate pattern; and dispensing material from the second dispensing unit at desired locations on the second electronic substrate pattern. In certain embodiments, the step of dispensing material from the first dispensing unit may comprise lowering the first dispensing unit toward the first electronic substrate pattern. Similarly, the step of dispensing material from the second dispensing unit may comprise lowering the second dispensing unit toward the second electronic substrate pattern.

Another exemplary dispense operation may consist of the following steps: delivering first and second electronic substrate patterns to respective dispense positions; positioning a first dispensing unit over the first electronic substrate pattern; positioning a second dispensing unit a predetermined distance from the first dispensing unit; dispensing material from the first dispensing unit at desired locations on the first electronic substrate pattern, wherein dispensing material from the first dispensing unit comprises lowering the first dispensing unit toward the first electronic substrate pattern; and dispensing material from the second dispensing unit at desired locations on the second electronic substrate pattern, wherein dispensing material from the second dispensing unit comprises, lowering the second dispensing unit toward the second electronic substrate pattern. In certain embodiments, the predetermined distance is determined by identifying a first point of reference associated with the first electronic substrate pattern and a second point of reference associated with the second electronic substrate pattern.

Yet another exemplary dispense operation for two substrates may consist of the following steps: (1) calibrating the actual distance between each of the dispensing units and the camera; (2) identifying the actual positions of the fiducial locations on a substrate or on multiple substrates; (3) moving the first dispensing unit to a first dispense location on a first substrate; (4) dispensing at the first dispense location on the first substrate; (5) moving the second dispensing unit to the first dispense location on the second substrate, which is a small and therefore rapidly performed movement; (6) dispensing at the first dispense location on the second substrate; and (7) repeating steps (3) through (6) for each of the remaining dispense locations on the substrates. The foregoing operation may be performed when dispensing on a single substrate having multiple patterns on the substrate.

In other embodiments of the disclosure, a dual-lane conveyor is incorporated into the system to handle work pieces. In such systems, the dispense units continue to dispense on parts fixed on one conveyor lane while parts are loaded off of and onto another conveyor lane.

In still other embodiments of the disclosure, aspects of the dual-lane conveyor are incorporated into multiple pallet loading fixtures. In such systems, the dispense units continue to dispense on parts fixed on one pallet while parts are loaded off of and then onto another pallet.

It is further contemplated that when using more than two dispensing units, that this approach of simultaneous dispensing on every other substrate may be employed. For example, when using three dispensing units, the first, third and fifth substrates may be dispensed upon simultaneously by the first, second and third dispensing units, respectively. After dispensing on these substrates, the dispensing units may be moved so that dispensing occurs on the second, fourth and sixth substrates with the first, second and third dispensing units, respectively.

In an exemplary embodiment, a method of dispensing material may include delivering an electronic substrate to a dispense position, the electronic substrate having at least two identical patterns, acquiring data relative to at least two patterns, determining whether the at least two patterns are properly suited for simultaneous dispensing to perform simultaneous dispense operations on the at least two patterns based on the acquired data, and performing simultaneous dispense operations on the at least two patterns if the two patterns are properly suited for simultaneous dispensing.

Dispensing material may include positioning a first dispensing unit over a first location of a first pattern and positioning a second dispensing unit over a first location of a second pattern. As discussed above, the second dispensing unit may be spaced from the first dispensing unit a predetermined distance. Specifically, material may be dispensed from the first and second dispensing units on respective first locations of the first and second patterns. Once dispensing takes place, the first dispensing unit is moved over a second location of the first pattern and the second dispensing unit is simultaneously moved over a second location of the second pattern of the electronic substrate. Once moved, material may be dispensed from the first and second dispensing units on respective second locations of the first and second patterns.

In another exemplary embodiment, a method of dispensing material may include (1) identifying positions of more than one location on an electronic substrate, (2) determining whether a dispense location of a first pattern and a dispense location of a second pattern are properly suited for simultaneous dispensing to perform simultaneous dispense operations on the first and second patterns based on the identified positions, (3) moving a first dispensing unit to a dispense location on the first pattern and a second dispensing unit to a dispense location on the second pattern, the dispense location of the first pattern corresponding with the dispense location on the second pattern, (4) dispensing at the first dispense location on the first pattern with the first dispensing unit and at the first dispense location on the second pattern with the second dispensing unit, and (5) repeating steps (3) and (4) for each remaining dispense location on the first and second patterns of the electronic substrate. As discussed above, prior to performing the method, a distance between the first dispensing unit and the camera and the distance between the second dispensing unit and the camera may be calibrated.

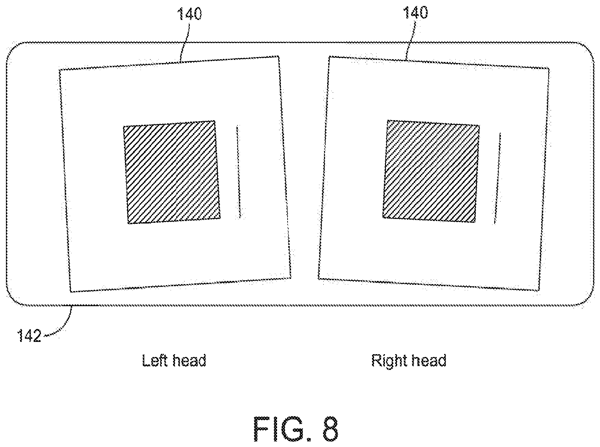

In one embodiment, to make a static one-time adjustment per substrate presented to the dispenser, the vision system and the controller locates and calculates the distance of one part in a substrate to another part in the same substrate, as well as any rotation of the substrate relative to the X/Y gantry, and adjust the second dispensing unit one time prior to dispensing simultaneously. In another embodiment, the automatic adjustment mechanism may be utilized to make dynamic adjustments while dispensing separate parts/substrates each indicated at 140 in a carrier, such as an Auer boat 142 shown in FIG. 8, which are not connected or accurately aligned with each other. In this case, the vision system would locate each part/substrate 140 in the carrier 142 and calculate the relative offset and rotation of each part/substrate. The dispenser would then begin dispensing a "master" substrate pattern, while simultaneously dispensing other substrates while dynamically adjusting the other dispensing units relative to the master.

Thus, when two patterns are not properly suited for simultaneous dispensing, or in instances in which two substrates are not properly suited for simultaneous dispensing, the method includes simultaneously performing a first dispense operation on the first pattern (or substrate) with the first dispensing unit and performing a second dispense operation on the second pattern (or substrate) with the second dispensing unit. This may be achieved by dynamically positioning the second dispensing unit with the automatic adjustment mechanism while continuing to dispense with the first and second dispensing units.

The dispenser of embodiments of the invention is capable of dispensing different patterns simultaneously. In such a method, the gantry carrying the dispensing units, as well as the automatic adjustment mechanism associated with the second dispensing unit (and/or the first dispensing unit), are manipulated to dispense different patterns simultaneously. Specifically, for dynamic adjustment, the two parts 140 illustrated in FIG. 8 are offset within the Auer boat 142. The right-hand, first dispensing unit is fixed, so a dispensing path of the first dispensing unit follows the movement of the main gantry. A dispensing path of the left-hand, second dispensing unit is calculated from the vision system and controlled by the automatic adjustment mechanism. With this method, lines dispensed by the first dispensing unit and the second dispensing unit may be drawn synchronously.

In one embodiment, the automatic adjustment mechanism of the dispenser is capable of moving the second dispensing unit a distance of 50 mm in the X axis direction and a distance of 12 mm in the Y axis direction. In another embodiment, the dispenser can be configured to enable one or both of the dispensing units to automatically pitch during setup.

Accordingly, for a dispenser having multiple dispensing units, the distance and relative position of each of the multiple dispensing units may be configured to match the distance and relative spacing between each of the multiple substrates or components. After collecting and analyzing alignment information from an automatic vision alignment system, a first of the multiple dispensing units is positioned over a first dispense location on the first substrate or component. After performing a dispense operation, the gantry may be manipulated to make any required X-Y plane position adjustment that may be necessary to align a second of the multiple dispensing units over the corresponding first dispensing location of the second of the multiple substrates or components. Since the distance and relative position between each of the multiple dispense units is substantially similar to, although not necessarily identical to, the distance and relative position between each of the multiple substrates or components, any such adjustment of the gantry will be very small and thus rapidly performed. Each of the remaining multiple dispense units may be similarly utilized to dispense material at the corresponding first dispense location on each of the remaining substrates or components before any large X and Y gantry motion is required. However, if the number of substrates or components is greater than the number of dispense units, then the gantry may need to be repositioned to complete the dispensing operations on all of the substrates. The method is repeated to dispense each of the second and subsequent dispense locations. It should be understood that steps may be interchanged as may be dictated by either throughput or process improvements.

As discussed above, in one embodiment, the dispensing units may be mounted on separate Z drive mechanisms. This configuration enables the performance of independent operations when appropriate, including but not limited to dispensing, cleaning (as by an automatic needle/nozzle cleaner, for example), purging and calibration (either the X/Y axes position or the Z axis position). However, it should be noted that the dispenser may be particularly suited for non-contact dispensing, such as the streaming or jetting of material from the needle/nozzle. When configured for non-contact dispensing, the dispensing operation may be performed with the two (or more) dispensing units that are mounted on a single Z drive mechanism.

One embodiment of the present disclosure is directed to a method of dispensing between synchronous and asynchronous modes. As mentioned above, when employing a vision system to determine whether a substrate or multiple substrates are properly suited for simultaneous dispensing, or whether a pattern or multiple patterns are properly suited for simultaneous dispensing, when properly suited for simultaneous dispensing, the substrates or patterns can be synchronously dispensed on by the dispensing units by employing a synchronous mode of operation. However, when not properly suited for simultaneous dispensing, the substrates or patterns can be automatically asynchronously dispensed independently by employing an asynchronous mode of operation.

As used herein, "properly suited for simultaneous dispensing" means that the two or more substrates or patterns are located at known locations as determined by the controller after examining data associated with one or more images taken by the vision system or camera, with such known locations being within a predetermined tolerance, and no other acquired data indicates a reason not to dispense on one or more of the substrates or patterns.

As used herein, "acquired data" means data generated internal to the dispense system, such as vision data or transferred from an external source based on previous processing.

In one embodiment, the mode of operation changes from synchronous mode to asynchronous mode if one or more of the substrates or patterns are determined to be skipped for at least one of the following reasons:
1. One or more of the substrates or patterns are not located within a predetermined tolerance.
2. The vision system fails to recognize one or more of the substrates or the patterns, and thus the substrate or pattern is deemed to be skipped.
3. One or more substrates or patterns is "bad marked" by a vision-based bad mark.
4. One or more substrates or patterns is "bad marked" by data acquired from previous processing of the substrates or patterns.
5. Inspection of a partially dispensed pattern determines there is an issue or problem, thus, the remainder of the process is skipped.

As used herein, "bad mark" a means of marking a part or portion of a part (pattern) to skip the given process within a particular production cell or piece of equipment. "Visual bad mark" means a bad mark which is a physical mark on the product which is inspected by the vison system of the process equipment and if found (or not found) determines whether or not the part is bad marked or good to process. "Electronic bad mark" means a bad mark which is determined by data presented to the process equipment, which determines which parts/portions of a product are bad marked or good to process.

By way of example, board serial ABCD has 8 portions/parts to process is given a data/electronic bad mark of 11100111, and will only process parts 1, 2, 3, 6, 7, 8 as parts 4, 5 are bad marked with a "zero" and therefore skipped. Thus, in one embodiment, when processing, the dispenser can be configured to operate in a synchronous mode for parts 1, 2 , 3 to an asynchronous mode for parts 4, 5, and back to a synchronous mode for parts 6, 7, 8. In another embodiment, upon recognizing bad marked parts 4, 5, the dispenser can be configured to operate solely in asynchronous mode to dispense on parts 1, 2, 3, 6, 7, 8. Skipped parts 4, 5 can be scrapped or reworked or otherwise processed at a later time.

Thus, methods of the present disclosure relate to a method of skipping a part or portion of a part based on the reasons noted, changing from synchronous to asynchronous modes processing. If using synchronous dispensing, parts can be properly dispensed by using synchronous mode or skipped as required by using asynchronous mode. The provision of synchronous and asynchronous modes of operation enables the ability of all parts within a given set to be dispensed upon or not dispensed and not skipped based on their status. Without such modes of operation, materials and time are wasted on parts that do not require processing.

In one preferred method, a method of dispensing material includes delivering an electronic substrate to a dispense position. The electronic substrate has at least two identical patterns. Once positioned, the method includes acquiring data relative to the at least two patterns and determining whether the at least two patterns are properly suited for simultaneous dispensing. If properly suited for simultaneous dispensing, the method includes performing simultaneous dispense operations on the at least two patterns based on the acquired data in a synchronous mode of operation. If not properly suited for simultaneous dispensing, the method includes performing one of (1) a first dispense operation on a first pattern of the at least two patterns and performing a second dispense operation on a second pattern of the at least two patterns, (2) a single dispense operation on one of the first pattern and the second pattern, and (3) no dispense operation, in an asynchronous mode.

In another preferred method, a method of dispensing material includes delivering a first electronic substrate to a first dispense position and delivering a second electronic substrate to a second dispense position. Once positioned, the method includes acquiring data relative to the first electronic substrate and the second electronic substrate and determining whether the first electronic substrate and the second electronic substrate are properly suited for simultaneous dispensing. If properly suited for simultaneous dispensing, the method includes performing simultaneous dispense operations on the first electronic substrate and the second electronic substrate based on the acquired data in a synchronous mode of operation. If not properly suited for simultaneous dispensing, the method includes performing one of (1) a first dispense operation on the first electronic substrate and performing a second dispense operation on the second electronic substrate, (2) a single dispense operation on one of the first electronic substrate and the second electronic substrate, and (3) no dispense operation, in an asynchronous mode.

With both preferred methods, asynchronous mode is triggered by (1) determining one or more of the substrates or patterns are not located within a predetermined tolerance; (2) failing to recognize one of the at least two patterns, (3) assigning a bad mark to data acquired prior to capturing the at least one image, (4) assigning a bad mark to data acquired from previous processing of an electronic substrate having at least two patterns, or (5) inspecting a partially dispensed pattern and determining a defect.

Having thus described several aspects of at least one embodiment of this disclosure, it is to be appreciated various alterations, modifications, and improvements will readily occur to those skilled in the art. Such alterations, modifications, and improvements are intended to be part of this disclosure, and are intended to be within the scope of the disclosure. Accordingly, the foregoing description and drawings are by way of example only.

## Claims

1. A method of dispensing material comprising:
delivering an electronic substrate (12) to a dispense position, the electronic substrate (12) having at least two identical patterns;
acquiring data relative to the at least two patterns;
determining whether the at least two patterns are properly suited for simultaneous dispensing; and
if properly suited for simultaneous dispensing, performing simultaneous dispense operations on the at least two patterns based on the acquired data in a synchronous mode of operation, and
**characterised in that**
if not properly suited for simultaneous dispensing, asynchronously performing one of
1. a single dispense operation on one of the first pattern and the second pattern, and
2. no dispense operation,
in an asynchronous mode of operation; and
**in that** the asynchronous mode is triggered due to one or more of:
- at least one of the at least two patterns not located within a predetermined tolerance;
- failing to recognize one of the at least two patterns;
- bad mark data associated with at least one of the at least two patterns;
- assigning a bad mark to data acquired from previous processing of an electronic substrate (12) having at least two patterns; and
- inspecting a partially dispensed pattern and determining a defect, and
wherein the or each pattern of the at least two patterns that triggered the asynchronous mode is skipped.

2. The method of claim 1, wherein the step of acquiring data includes capturing and processing at least one image of the at least two patterns.

3. A method of dispensing material comprising:
delivering a first electronic substrate (12A) to a first dispense position;
delivering a second electronic substrate (12B) to a second dispense position;
acquiring data relative to the first electronic substrate (12A) and the second electronic substrate (12B);
determining whether the first electronic substrate (12A) and the second electronic substrate (12B) are properly suited for simultaneous dispensing; and
if properly suited for simultaneous dispensing, performing simultaneous dispense operations on the first electronic substrate (12A) and the second electronic substrate (12B) based on the acquired data in a synchronous mode of operation, and
**characterised in that**
if not properly suited for simultaneous dispensing, asynchronously performing one of
1. a single dispense operation on one of the first electronic substrate (12A) and the second electronic substrate (12B), and
2. no dispense operation,
in an asynchronous mode of operation; and
**in that** the asynchronous mode is triggered due to one or more of:
- one of the first electronic substrate (12A) and the second electronic substrate (12B) not located within a predetermined tolerance;
- failing to recognize one of the first electronic substrate (12A) and the second electronic substrate (12B);
- bad mark data associated with at least of the first electronic substrate (12A) and the second electronic substrate (12B);
- bad mark data acquired from previous processing of at least one of the first electronic substrate (12A) and the second electronic substrate (12B); and
- inspecting a partially dispensed pattern and determining a defect, and
wherein the or each electronic substrate of the first electronic substrate (12A) and second electronic substrate (12B) that triggered the asynchronous mode is skipped.

4. The method of claim 3, wherein the step of acquiring data includes capturing and processing at least one image of the first electronic substrate (12A) and the second electronic substrate (12B).

## Patentansprüche

1. Verfahren zum Ausgeben von Material, aufweisend:
Zuführen eines elektronischen Substrats (12) an eine Ausgabeposition, wobei das elektronische Substrat (12) mindestens zwei identische Muster aufweist;
Erfassen von Daten in Bezug auf die mindestens zwei Muster;
Bestimmen, ob die mindestens zwei Muster wirklich für die gleichzeitige Ausgabe geeignet sind; und
wenn sie wirklich für die gleichzeitige Ausgabe geeignet sind, Ausführen von gleichzeitigen Ausgabevorgängen an den mindestens zwei Mustern basierend auf den erfassten Daten in einem synchronen Betriebsmodus, und
**dadurch gekennzeichnet, dass**,
wenn sie nicht wirklich für die gleichzeitige Ausgabe geeignet sind, asynchrones Durchführen eines von
1. einem Einzelausgabevorgang an einem von dem ersten Muster und dem zweiten Muster, und
2. keinem Ausgabevorgang, in einem asynchronen Betriebsmodus; und
dass der asynchrone Modus infolge von einem oder mehreren der folgenden ausgelöst wird:
- mindestens eines der mindestens zwei Muster befindet sich nicht innerhalb einer vorbestimmten Toleranz;
- Nichterkennen eines der mindestens zwei Muster;
- fehlerhafte Markierungsdaten, die mit mindestens einem der mindestens zwei Muster assoziiert sind;
- Zuordnen einer fehlerhaften Markierung zu Daten, die von der vorherigen Verarbeitung eines elektronischen Substrats (12) mit mindestens zwei Mustern erfasst wurden; und
- Inspizieren eines teilweise ausgegebenen Musters und Bestimmen eines Defekts, und wobei das oder jedes Muster der mindestens zwei Muster, die den asynchronen Modus auslösten, übersprungen wird.

2. Verfahren nach Anspruch 1, wobei der Schritt des Erfassens von Daten ein Erfassen und Verarbeiten mindestens eines Bilds der mindestens zwei Muster beinhaltet.

3. Verfahren zum Ausgeben von Material, aufweisend:
Zuführen eines ersten elektronischen Substrats (12A) zu einer ersten Ausgabeposition;
Zuführen eines zweiten elektronischen Substrats (12B) zu einer zweiten Ausgabeposition;
Erfassen von Daten in Bezug auf das erste elektronische Substrat (12A) und das zweite elektronische Substrat (12B);
Bestimmen, ob das erste elektronische Substrat (12A) und das zweite elektronische Substrat (12B) wirklich für die gleichzeitige Ausgabe geeignet sind; und
wenn sie wirklich für die gleichzeitige Ausgabe geeignet sind, Ausführen von gleichzeitigen Ausgabevorgängen an dem ersten elektronischen Substrat (12A) und dem zweiten elektronischen Substrat (12B) basierend auf den erfassten Daten in einem synchronen Betriebsmodus, und
**dadurch gekennzeichnet, dass**,
wenn sie nicht wirklich für die gleichzeitige Ausgabe geeignet sind, asynchrones Durchführen eines von
1. einem Einzelausgabevorgang an einem von dem ersten elektronischen Substrat (12A) und dem zweiten elektronischen Substrat (12B), und
2. keinem Ausgabevorgang, in einem asynchronen Betriebsmodus; und
dass der asynchrone Modus ausgelöst wird und mindestens ein Muster übersprungen wird infolge von einem oder mehreren der folgenden:
- eines von dem ersten elektronischen Substrat (12A) und dem zweiten elektronischen Substrat (12B) befindet sich nicht innerhalb einer vorbestimmten Toleranz;
- Nichterkennen eines von dem ersten elektronischen Substrat (12A) und dem zweiten elektronischen Substrats (12B);
- fehlerhafte Markierungsdaten, die mit mindestens dem ersten elektronischen Substrat (12A) und dem zweiten elektronischen Substrat (12B) assoziiert sind;
- fehlerhafte Markierungsdaten, die aus einer vorherigen Verarbeitung des mindestens einem von dem ersten elektronischen Substrat (12A) und dem zweiten elektronischen Substrat (12B) erfasst wurden; und
- Inspizieren eines teilweise ausgegebenen Musters und Bestimmen eines Defekts, und
wobei das oder jedes elektronische Substrat von dem ersten elektronischen Substrat (12A) und dem zweiten elektronischen Substrat (12B), das den asynchronen Modus auslöste, übersprungen wird.

4. Verfahren nach Anspruch 3, wobei der Schritt des Erfassens von Daten ein Erfassen und Verarbeiten von mindestens einem Bild des ersten elektronischen Substrats (12A) und des zweiten elektronischen Substrats (12B) beinhaltet.

## Revendications

1. Procédé de distribution de matériau comprenant :
fourniture d'un substrat électronique (12) à une position de distribution, le substrat électronique(12) ayant au moins deux motifs identiques ;
l'acquisition de données relatives aux au moins deux motifs ;
le fait de déterminer si les au moins deux motifs sont convenablement adaptés pour une distribution simultanée ; et
s'ils conviennent pour une distribution simultanée, la réalisation d'opérations de distribution simultanées sur les au moins deux motifs sur la base des données acquises dans un mode de fonctionnement synchrone, et
**caractérisé en ce que**
s'ils ne sont pas appropriés pour une distribution simultanée, la réalisation de manière asynchrone l'un parmi
1. une opération de distribution unique sur l'un parmi le premier motif et le deuxième motif, et
2. aucune opération de distribution, dans un mode de fonctionnement asynchrone ; et
**en ce que** le mode asynchrone est déclenché en raison d'un ou de plusieurs parmi :
- au moins l'un des au moins deux motifs ne se trouve pas au sein d'une tolérance prédéterminée ;
- l'échec de la reconnaissance de l'un parmi les au moins deux motifs ;
- les données de point de pénalisation associées à au moins l'un parmi les au moins deux motifs ;
- l'attribution d'un point de pénalisation à des données acquises à partir d'un traitement précédent d'un substrat électronique (12) ayant au moins deux motifs ; et
- l'inspection d'un motif partiellement distribué et la détermination d'un défaut, et dans lequel le ou chaque motif des au moins deux motifs qui a déclenché
le mode est sauté.

2. Procédé selon la revendication 1, dans lequel l'étape d'acquisition de données comporte la capture et le traitement d'au moins une image des au moins deux motifs.

3. Procédé de distribution de matériau comprenant :
l'apport d'un premier substrat électronique (12A) jusqu'à une première position de distribution ;
l'apport d'un deuxième substrat électronique (12B) jusqu'à une deuxième position de distribution ;
l'acquisition de données relatives au premier substrat électronique (12A) et au deuxième substrat électronique (12B) ;
le fait de déterminer si le premier substrat électronique (12A) et le deuxième substrat électronique (12B) sont convenablement adaptés pour une distribution simultanée ; et
s'ils conviennent pour une distribution simultanée, la réalisation d'opérations de distribution simultanées sur le premier substrat électronique (12A) et sur le deuxième substrat électronique (12B) sur la base des données acquises dans un mode de fonctionnement synchrone, et
**caractérisé en ce que**
s'ils ne sont pas appropriés pour une distribution simultanée, la réalisation de manière asynchrone l'un parmi
1. une opération de distribution unique sur l'un parmi le premier substrat électronique (12A) et le deuxième substrat électronique (12B), et
2. aucune opération de distribution, dans un mode de fonctionnement asynchrone ; et
**en ce que** le mode asynchrone est déclenché et au moins un motif est sauté en raison d'un ou plusieurs parmi :
- l'un parmi le premier substrat électronique (12A) et le deuxième substrat électronique (12B) qui ne se trouve pas au sein d'une tolérance prédéterminée ;
- l'échec de la reconnaissance de l'un parmi le premier substrat électronique (12A) et le deuxième substrat électronique (12B) ;
- les données de point de pénalisation associées au moins l'un parmi le premier substrat électronique (12A) et le deuxième substrat électronique (12B) ;
- les données de point de pénalisation acquises à partir du traitement précédent d'au moins l'un parmi le premier substrat électronique (12A) et le deuxième substrat électronique (12B) ; et
- l'inspection d'un motif partiellement distribué et la détermination d'un défaut, et
dans lequel le ou substrat électronique parmi le premier substrat électronique (12A) et le deuxième substrat électronique (12B) qui a déclenché le mode asynchrone est sauté.

4. Procédé selon la revendication 3, dans lequel l'étape d'acquisition de données comporte la capture et le traitement de l'au moins une image du premier substrat électronique (12A) et du deuxième substrat électronique (12B).
